# EUROPEAN PATENT SPECIFICATION

(11) **EP 1 845 385 B1**
(45) Date of publication and mention of the grant of the patent: **15.10.2008**
(21) Application number: 06112885.6
(22) Date of filing: 21.04.2006
(51) Int. Cl.: G01R 31/317

(54) **Time interval analysis of digital data**
Zeitintervallanalyse digitaler Daten
Analyse de l'intervalle de temps de données numériques

(43) Date of publication of application: 17.10.2007
(73) Proprietor: Agilent Technologies, Inc., Santa Clara, CA 95051 (US)
(72) Inventor: Moll, Joachim, 71083 Herrenberg (DE)
(74) Representative: Barth, Daniel Mathias

(56) References cited:
- US-A1- 2003 004 664
- ANONYMOUS: "Analyzing Digital Jitter and its Components" [Online] 22 January 2004 (2004-01-22), AGILENT TECHNOLOGIES , 2004 HIGH-SPEED DIGITAL DESIGN SEMINAR , XP002400434 Retrieved from the Internet: URL:http://www.home.agilent.com/upload/cmc _upload/All/Analyzing_Digital_Jitter_and_i ts_Components.pdf> * pages 4-10 - pages 4-12 *
- ANONYMOUS: "Fibre Channel - Methodologies for Signal Quality Specification -MSQS" [Online] 22 November 2005 (2005-11-22), INCITS , XP002400435 Retrieved from the Internet: URL:http://www.t11.org/FTP/T11/PUB/FC/MSQS /05-793V0.PDF> * the whole document * * page 87 - page 93 *

## Description

### BACKGROUND ART

The present invention relates to time domain analysis of a digital data signal.

Characterizing the transient behavior of high-speed digital circuits, i.e. the transition from a logical zero to a logical one and vice versa, has become increasingly important for designing as well as manufacturing such digital circuits. Timing problems can cause single transmission errors, or temporary or even permanent outage of an entire communication system, and have to be avoided.

A standard characterization of digital circuits is the so-called Bit Error Ratio (BER), i.e. the ratio of erroneous bits to the total number of regarded bits. Therefore, a received digital data signal is repetitively sampled at defined sample points. Each sampling point is determined by a threshold value for comparing the response signal with an expected signal, and by a relative time (e.g. with respect to corresponding transition of a clock signal - usually the system clock for generating the stimulus signals or a clock signal derived therefrom or from the response signal).

[0003a] A further technique of determining the characteristics of digital data signals is real time sampling or equivalent sampling of such signals by so-called sampling oscilloscopes. Thereby, samples are targeted at specific time delays with respect to a trigger signal. In order to determine the position of an edge within the signal, the signal value at such targeted time is determined and the position of the edge is determined by fitting the signal value to a predefined or acquired edge model. Such measurements can be determined by appropriate digital oscilloscopes, such as the Agilent 86100 Series digital sampling oscilloscopes provided by the applicant Agilent Technologies, the Agilent 86100 Series oscilloscopes being able for sampling high speed digital data signals having edges with rise and fall times below 20 picoseconds.

US 2003/004664 A1 discloses spectrum analysis-based serial data jitter measurement. Further prior art is disclosed in ANONYMOUS: "Analyzing Digital Jitter and its Components" [Online] 22 January 2004 (2004-01-22), AGILENT TECHNOLOGIES, 2004 HIGH-SPEED DIGITAL DESIGN SEMINAR, XP002400434, and ANONYMOUS: "Fibre Channel - Methologies for Signal Quality Specification - MSQS" [Online] 22 November 2005 (2005-11-22), INCITS, XP002400435. The teaching of the latter document forming the preamble to the independent claims.

### DISCLOSURE OF THE INVENTION

It is an object of the invention to provide an improved time domain analysis. The object is solved by the independent claims. Preferred embodiments are shown by the dependent claims.

While BERT measurements provide information about average signal behaviors, it is often necessary to determine further properties, e.g. signal edge to signal edge time distances or intervals, wherein the signal edges might be adjacent edges, e.g. the rising and falling edge of one bit or plurality of similar non-return-to-zero (NRZ) bits or return-to-zero (RZ) bits, or non-adjacent bits with a plurality of signal edges in-between. It is further often required to determine variations in such time distances of a plurality of measurements, further also referred to as cycle-to-cycle jitter or n-cycle jitter.

According to embodiments of the present invention, a time interval analyzer is provided for determining a time interval between two signal edges of one data signal or more data signals, each comprising a sequence of a plurality of bits, wherein the bits are located at equidistant time points according to a corresponding clock signal. The data signal(s) might be provided by a device under test -DUT- that is to be tested according to specifications. The invention is based on the insight that signal edges in high speed signals show significant durations of transition. The knowledge of an edge shape allows for sampling the signal once in such transition region and fitting the sampled value to the known edge shape. Therewith it is possible to exactly timely locate the edge. Incorporating such time interval analyzer into an under-sampling oscilloscope (i.e. into an oscilloscope having a sampling below the data rate of the sampled signals) allows exactly determining timings of signal edges.

In an embodiment, the analyzer stores, produces or accesses one or more edge models describing the signal value over the time within a transition region.

In an embodiment, time intervals between edges (e.g. a rising edge and a falling edge) of a data signal or between edges of different data signals (e.g. two rising edges of each one data signal) are determined. Therefore, a first time difference between a first signal sample and a defined signal value and a second time difference between a second signal sample and the defined signal value is determined. The time interval between the edges can be determined on the base of the known trigger time difference and the first and second time differences.

In an embodiment, a time interval analyzer for determining the time intervals accesses one or more edge models, e.g. one edge model, if the rising edge and a corresponding magnitude-inverted falling edge of a data signal to be analyzed are similar, each a rising edge model characterizing the rising edges and a falling edge model characterizing the falling edges of a data signal to be analyzed, or a plurality of edge models each pertaining to different data signals to be analyzed.

According to further embodiments, the time interval analyzer comprises a sampling circuit for sampling the data signal at one time point or a plurality of different time points. Thereby corresponding sampling time points are derived from the clock signal such that the signal is sampled in regions of signal transitions (or edge regions). Therewith two signal (magnitude) values of edges of interest are obtained being different from both the minimum signal value (i.e. the signal low level) and the maximum signal value (i.e. the signal high level). The analyzer further stores, produces or accesses one or more edge models (e.g. one edge model if the rising edge and the inverted falling edge are similar or each a rising edge model and a falling edge model otherwise, or multiple edge models for different bit histories). The edge models describe the signal value over the time. Therefrom, a first time difference between the first signal sample and a defined signal value, further also being referred to as timing reference value, and a second time difference between the second signal sample and the defined signal value is determined.

The time interval between both edges can be obtained on the base of the determined time differences and a known time difference between the sampling time points. If a positive time difference is defined as a time delay of a sampling time point with respect to the corresponding edge time point (i.e. the time of the edge center or any other defined edge point) and the corresponding sample time point, and a negative time difference correspondingly denotes a time advance, the time interval can be calculated by taking the time difference between the time difference between the sampling time points and the resulting time difference between the second time difference and the first time difference.

Preferably, the sampling time points are determined according to the clock signal relating to the data signal(s). Thereby, the time points are chosen such that they are close to the defined edge points, but at least in an edge region showing a significant signal value change over time.

The time interval analyzer might receive the clock signal separately from the data signal(s). Thereby, the clock signal might be generated by a testing unit providing each the DUT and the time analyzer with the clock signal. Alternatively, the time analyzer uses a stable internally or externally generated clock having a defined frequency relation with respect to the DUT clock frequency. Further alternatively, the time analyzing unit might recover the clock signal from (one of) the data signal(s) by means of a clock recovery circuit.

In a further embodiment, a time interval between the first signal edge and the second signal edge is determined by taking the difference between the trigger times and a resulting time difference between the second time difference, and the first time difference.

In a further embodiment, the measurement of time differences is repeated for a plurality of similar time intervals, e.g. for a fraction of a bit cycle in the case of determining variations of return-to-zero time intervals, one bit cycle in the case of determining cycle-to-cycle time variations or a plurality of bit cycles for determining variations of a plurality of bit cycles. If the data signal comprises a multiple repetition of a test sequence, e.g. a 1000-time repetition of a defined bit pattern, wherein the bit pattern might be a pseudo random bit sequence generated by a linear feedback shift register circuit or any other pattern containing a plurality of frequency components and therewith suitable for timing test purposes.

From these measurements, jitter characteristics of the data signal can be derived. A first jitter property can be derived by determining each a distribution function over the time of the first and second time differences, determining each the mean value, and determining the difference between both mean values.

If only measurements of bit time intervals having the same bit history, e.g. of the bit intervals at each the same position within the repeated bit pattern are performed, such mean value difference denotes the jitter components excluding data dependent jitter. A further jitter component can be derived by determining a distribution function of the differences of the second time difference and the first time difference over the time. If such a distribution is determined for all bit cycles (or n-bit cycles) of the data signal, the widths of such distribution (i.e. the minimum and maximum values) denotes an overall cycle-to-cycle jitter including data dependent jitter and random jitter. If such distribution is performed for bit time intervals having the same bit history, such widths denotes random and periodic cycle-to-cycle jitter.

In a further embodiment, time intervals between signal edges of a first data signal and a thereto related clock signal or second data signal are collected. The same type of analyses as described above might be performed on the time intervals. Further such analysis can be used for synchronizing the first data signal to the clock signal.

In an embodiment, a signal analyzer comprising an analog sampling circuit and a digital sampling circuit is provided. The analog sampling circuit samples, at first trigger points, analog values of the data signal, preferably in a transition region, converts this values into (multi-bit) digital values and provides these first values to an analyzing circuit. The digital sampling circuit samples the data signal, preferably in the bit center region, i.e. in the center of the data eye of the data signal, i.e. in a region between signal transitions, at a plurality of subsequent second trigger time points, reproduces a bit sequence of the data signal, and provides these second values to the analyzing circuit. The analyzing circuit provides a signal analysis based on both first and second values.

With the digital sampling circuit a number second values representing a number of preceding bits relative to a transition (bit history) and (at least one) following bit(s) are stored together with the first value representing the transition value sampled by the analog sampling circuit.

In further embodiment, the bit sequence of the data signal is determined by comparing the data signal with a threshold, assigning one of two bit values depending on the comparison result (e.g. a "0" value, if the comparison result is negative and a "1" value if the comparison result is positive) at successive trigger points.

In a further embodiment the analog sampling circuit comprises a sample&hold circuit (or a track&hold circuit), and an analog-to-digital converter. The sample&hold circuit receives first trigger signals and provides each an analog value (e.g. an analog voltage) of the data signal at a corresponding first trigger times and keeps this values each stored for a certain amount of time. The analog-to digital converter converts the received analog value into a multi bit digital value, e.g. being represented as 12 bit data or 16 bit data.

In a further embodiment, the analyzing circuit keeps stored one or a plurality of edge models for characterizing a signal transition between the digital magnitude levels (low level and high level) of the data signal. The edge model describes the expected signal value over the time of the data signal. Fitting the said edge model the detected signal value, the difference in magnitude between said detected signal value and predefined signal value, wherein the predefined might e.g. represent the center values at a 50% level between the low level and the high level, is transformed into a time difference value. By relating the time difference value to the trigger signal, the exact position of the signal edge can be determined.

In a further embodiment, the data signal is analyzed with respect to a depth of influence of previous bits to an actual transition, or in other words with respect to the influence of the bit history. This influence can be denoted as number of preceding bits. The sequences of a defined number of digital values provided by the digital sampling circuit are collected with respect to the transitions to be analyzed, i.e. each first (multi-bit) sample value is assigned to a certain sequence of second sample (single bit values), also being referred to as bit history.

In order to determine a number of preceding subsequent bits influencing an actual transition, i.e. to determine a depth of influence of previous bits to an actual transition, sampled values of repetitive measurements are sorted or binned according to their bit history, e.g. binned to eight different groups each related to one history of a three bit sequence. Such binning is further extended to longer history as long as they show different mean values with respect to the clock signal.

In a further embodiment, a signal analysis is carried out for determining non data dependent jitter characteristics by generating trigger signals on the condition that a defined history, i.e. a defined bit sequence of the data signal is being detected.

If the influence is found to be limited to a number of n bits, a determination of jitter excluding data depending jitter might be carried out by detecting a certain sequence n bits and triggering on each occurrence of this pattern. This is in particular advantageous, if long bit sequences are used, where an analysis of every edge position would take too long.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In a further embodiment, the analyzing circuit comprises a processing unit for storing the one or more edge models in terms of digital values, e.g. arranged in tables of time/signal value pairs, or in terms of an algorithm providing digital values. Therewith, the above-described time differences are determined by a digital calculation of the computer. Such models and algorithms might be stored in for of software programs.

.The timing reference value of the edge model can be any value between the low level and the high level, e.g. the 50% level in the middle between those levels, or in the geometric center of the edge model and/or the most likely transition point.

The model can be stored as polynomial best fit curve of a real signal edge, a as section-wise curve composed of one or more linear or polynomial sections, as values of measured edge curves, or as a curve composed of a plurality of measured edge curves.

In a further embodiment, the analyzer might comprise a first sample&hold circuit for receiving the first trigger signal at its trigger input and the data signal at its signal input, and a second sample&hold circuit for receiving the second trigger signal at its trigger input and the data signal at its signal input. The signal outputs of the first and second sample&hold circuits might be connected each over a first and a second transfer gate to the converter circuit. Therefore, the control circuit alternately switches the transfer gates in order to provide the first signal sample and the second signal sample alternately to the converter circuit. Alternately, a first and a second converter circuit are comprised, wherein the first sample&hold circuit provides the first signal sample to the first converter circuit, and the second sample&hold circuit provides the second signal sample to the second converter circuit.

In a further embodiment, the analyzer comprises a first high bandwidth sample&hold circuit for receiving the first trigger signal and the second trigger signal at its trigger input and the data signal at its signal input. Further, two relatively low bandwidth sample&hold circuits are provided to each receive at their signal inputs a signal output from the first sample&hold circuit, whereby such circuits are differently triggered such that the values captured by the first trigger circuit are alternately provided at the outputs of the third and fourth trigger circuit. There from, these values might be each provided to one common analog-to-digital converter or to two different analog-to-digital converters. Therewith, instead of providing two high bandwidth sample&hold circuits, only one high bandwidth sample&hold circuit needs to be provided, whereby the one or more analog-to-digital converters might have less speed requirements. This allows for high precision time interval analysis of high speed data signals with only one correspondingly high speed and high bandwidth circuit.

One limitation of the above-described method is that the trigger time points must be chosen to trigger the signal with transition areas, as otherwise it might not be possible to perform a value fitting to the stored modes. In order to enhance the trigger time range, where trigger signal can be placed, the time width of the transition areas, i.e. the transition time, might be increased. Therefore, a filter showing a linear phase response might be connected between a data input and the sampling circuit. This filter decreases the (absolute) gradient of the signal edges without influencing the jitter properties of the data signal.

In a further embodiment, the trigger time interval measurement range is extended by placing a plurality of trigger signals at a defined distance to each other. The distance is preferably chosen to be equal to a measurement or trigger time range of a single transition. This allows for multiplying the resulting measurement range by the number of trigger signals.

In a further embodiment, an extended sampling circuit is provided comprising a plurality of sampling paths, each comprising a sample&hold circuit and an analog-to-digital converter. A data signal to be sampled is provided to each one sample&hold circuit. Further, a trigger control circuit is provided for generating a plurality of subsequent trigger signals in response to a clock signal. The trigger signals are provided to each a trigger input of the sample&hold circuits. The outputs of the sample&hold circuits are connected to each one of the analog-to-digital converters. The corresponding digital values generated by the analog-to-digital converters are provided to an analyzing circuit that might chose the most significant value (i.e. the value not close or equal to the "low" or "high" signal level) for further edge fitting.

Alternatively, the extended digital trigger circuit might comprise only one sampling path comprising a sample&hold circuit and an analog-to-digital converter. The data signal to be sampled is provided to the sample&hold circuit. Further, a trigger control circuit is provided for generating a plurality of subsequent trigger signals in response to a clock signal. The trigger signals are provided to the sample&hold circuit. The sample&hold circuit generated a plurality of analog sample values in response to each trigger signal. These trigger signal might be provided to one analog-to-digital converter or to a plurality of analog-to-digital converters, e.g. being subsequently switched to the output of the sample&hold circuit by means of fast switchable transfer gates. Similarly to the previous embodiment, the analyzing circuit receives the analog values for further processing.

In a further embodiment, a time interval analyzer for sampling two signal edges of interest in order to derive a time interval between said edges might apply for each edge sampling an extended measurement as described before. Therefore, e.g. for duplicating the measurement range, four corresponding trigger signals are provided to one or a plurality of sample&hold circuits. The analyzing circuit receiving four analog values first might chose for each edge one value to be further processed. From the selected values, a first time difference and a second time difference between the might be determined as described above.

Alternatively, the sample&hold circuits of the above embodiments might be replaced by so-called track&hold circuits.

Embodiments of the invention can be partly or entirely embodied or supported by one or more suitable software programs, which can be stored on or otherwise provided by any kind of data carrier, and which might be executed in or by any suitable data processing unit.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference sign(s).
Fig. 1a shows a block diagram of a test setup with a DUT and a time interval analyzer according to an embodiment of the invention, wherein a data clock is directly provided in addition to the data signal,
Fig. 1b shows a block diagram of a test setup with a DUT and a time interval analyzer according to a further embodiment of the invention, wherein the time interval analyzer comprises a clock recovery circuit for detecting the data clock signal from the data signal,
Fig. 2a shows a diagram with a fraction of an first exemplary data signal over the time with exemplary time measurement values relating to a time interval between two adjacent signal edges,
Fig. 2b shows a diagram with fraction of a second exemplary data signal over the time with exemplary time measurement values between signal edges at a distant of a plurality of clock cycles,
Fig. 2c shows a schematic diagram with a distribution of rising edge times and falling edge times of repeated measurements at each one bit with the same bit history,
Fig. 2d shows a schematic diagram with a distribution of resulting cycle times of the measurement of Fig.2c,
Fig.3 shows a schematic block diagram of a sampling device comprising a digital sampling path and an analog sampling path according to a further embodiment of the invention,
Fig.4 shows a tree diagram with different hierarchies of bit history to a rising edge being collected in different bins and exemplary time distributions of different bins,
Fig.5a shows a schematic block diagram of a sampling device with an enhanced measurement range according to a further embodiment of the invention,
Fig.5b shows an exemplary sampling diagram pertaining to Fig.5a,
Fig. 6a shows a more detailed block diagram of the time interval analyzer according to Fig.1a or Fig.1b comprising a digital sampling path according to Fig.3,
Fig. 6b shows a variant of Fig.6a with two analog-to digital converters,
Fig.6c shows a variant of Fig.6b with a sampling circuit comprising three sample&hold circuits, and
Fig.7 shows schematic diagrams describing a jitter separation with bit history consideration

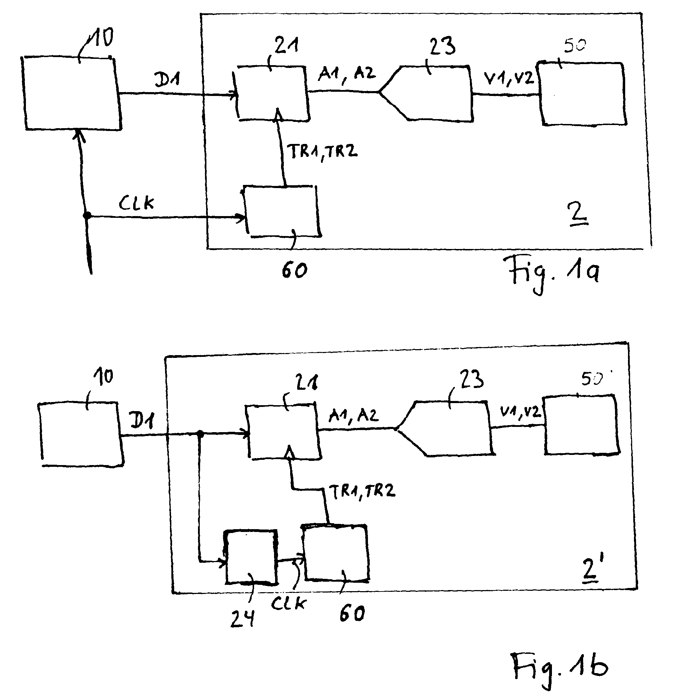

Fig. 1 a shows a block diagram of a first test setup with a DUT 10 and a time interval analyzer 2. The time interval analyzer 2 comprises a sampling circuit 21, an analog-to-digital converter 23, a trigger circuit 60 and analyzing circuit 50. A data clock signal CLK is provided to the DUT 1 and the trigger circuit 60. The DUT 10 generates a data signal D1 based on the clock signal CLK. The trigger circuit 60 generates a trigger signal comprising a first trigger pulse TR1 at a first trigger time t1 within a region of a first signal transition and a second trigger pulse (TR2) at a second trigger time T2 within a region of a second signal transition on the base of the received clock signal CLK. For determining the time duration of one bit, the control circuit generates the first trigger signal TR1 positioned at a rising edge of the data signal and generates the second trigger signal at a time distance of one cycle time in reference to the first trigger signal. The cycle time can be determined by measuring an average cycle time of the received clock signal or from predetermined parameters. The sampling circuit 21 receives the first trigger pulse TR1 and the second trigger pulse TR2, and takes a first signal sample A1 and a second signal sample A2 from the data signal D1 at said first and second trigger time T1 and T2 respectively. These analog values A1 and A2 are provided to the analog-to-digital converter 23 that converts these values into digital signal values V1 and V2, and provides these values to the analyzing circuit 50. The analyzing circuit 50 keeps stored one or a plurality of edge models, e.g. a rising edge models characterizing the rising edge and a falling edge model characterizing the falling edge. The edge models describe the expected signal value over the time of the respective data signal D1.

Such edge models might be stored in form of a plurality of (multi-bit) digital data (e.g. 12 bit data or 16 bit data) with a certain time resolution. Alternatively, the edge model can be stored e.g. as polynomial best fit curve of a most likely edge or a (time or magnitude) section-wise curve composed of one or more linear or polynomial sections. The data might be stored in a memory or data base being part of or being accessible by the time interval analyzer.

By fitting the detected signal values to the corresponding edge models, the difference in magnitude between said detected signal values and predefined signal values, can be, are transformed into time difference values.

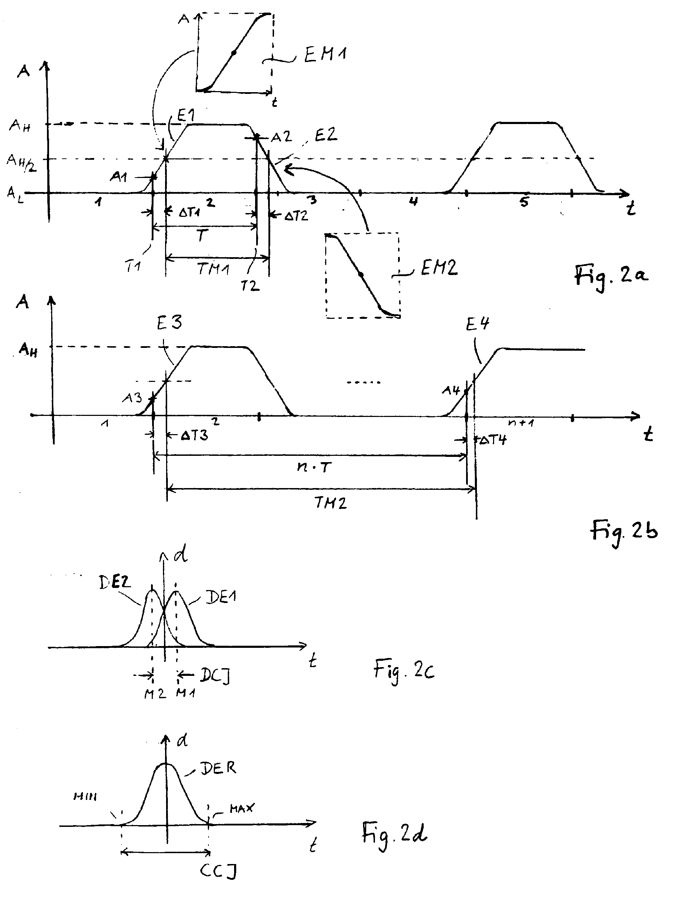

For determining a time interval between two signal edges, for each edge, the time distance between the corresponding time points of the fitted detected signal value and of a predefined transition value, e.g. the center value at a 50% level between the "low" bit signal level and a "high" bit signal level is determined. From the time difference values determined for two edges of a signal interval and a known time difference between the first trigger pulse TR1 and the second trigger pulse TR2, the analysing circuit 50 might determine a plurality of timing characteristics, e.g. signal jitter characteristics as described under Fig.2c - Fig2d can be derived.

Fig.1b shows a block diagram of a further test setup with the DUT 10 and an alternative time interval analyzer 2' additionally comprising a clock recovery circuit 24 compared to the time interval analyzer 2 of Fig.1a. Here, the clock signal CLK is not provided to the time interval analyzer 2', but instead the data signal D1 is provided both to the sampling circuit 21 and to the clock recovery circuit 24. The clock recovery circuit 24 derives the clock signal related to the data signal and provides this signal to the control circuit 60. Timing values are then measured relatively to the recovered clock.

Alternatively, not shown in the previous figures, the time interval analyzer might use an internal sampling clock, preferably having substantially the same frequency as the DUT.

Fig.2a shows a first diagram with the signal magnitude A of a non-return-to-zero (NRZ) data signal over the time t. The data signal exemplarily comprises a bit sequence "01001" within the bit cycles 1-5. By way of example the low signal level AL representing a "0" bit equals zero. Therewith, the 50% level between said low signal level AL and the high signal level AH representing a "1" equals AH/2.

Exemplarily, a first time interval TM1 between a rising signal edge E1 and a falling signal edge E2 of the second bit is determined. The data signal is sampled at a first sample time T1 obtaining a corresponding first signal sample A1 and at a second sample time T2, obtaining a corresponding second signal value A2. These values are fitted to a rising edge model EM1 and a falling edge model EM2 respectively. The edge models EM1 and EM2 describe the edge characteristics of the data signal D1. From the difference in magnitude between the first sampled value A1 and a center value at the 50% signal level, and the second sampled value A2 and the center value at the 50% signal level, the time differences or deviations Δt1 and ΔT2 for each the rising edge and the falling edge respectively are determined. As the difference between the first sample time T1 and the second sample time T2 corresponds to the bit cycle time T, the time interval TM1 is obtained by subtracting the rising edge time deviation Δt1 from the cycle time T and adding the falling edge time deviation ΔT2 thereto.

Fig.2b shows a variation of a measurement of Fig.1 for a multi cycle time interval TM2. The data signal exemplarily comprises a third rising edge between the first and the second bit cycle and a fourth rising edge between the n-th bit cycle and the (n+1)-th bit cycle. Corresponding to Fig.2a, third and forth time differences ΔT3 and ΔT4 for both rising edge are determined and the difference between both edges is determined by subtracting the third time deviation ΔT3 from the n-cycle time nT and adding the fourth time difference ΔT4 thereto.

Fig. 2c shows a schematic diagram with a first distribution DE1 of all rising edge times and a second distribution DE2 of all falling edge times over the time t as result of repeated measurements at each one bit with the same bit history, e.g. at each the same position within the repeated test bit pattern or with a same history of a defined length as described above. The test bit pattern might be a pseudo random bit sequence of length 2¹⁵ -1 being repeated 1000 times. For both distribution DE1 and DE2, mean values M1 and M2 are determined. The difference between the mean values M1 and M2 denotes a so-called duty cycle distortion (DCD) of the data signal.

Fig.2d shows a schematic diagram with a third distribution DER of a bit interval TM1 again as result of repeated measurements at each one bit with the same bit history. As the cycle time T is constant, the variation of the bit interval equals the variation of the difference between the time differences Δt1 and ΔT2. The difference between a maximum bit interval MAX and a minimum bit interval MIN denotes the peak-to-peak value of the cycle-to cycle jitter. If only bits with the same bit history are measured, this value does not comprise data dependent jitter DDJ, but random jitter and periodic jitter.

As alternative, all bit interval of a repeated test sequence might be measured regardless the bit history. In this case, the difference between a maximum bit interval MAX and a minimum bit interval MIN denotes a peak-to-peak value the cycle-to cycle overall jitter including data dependent jitter DDJ. The data dependent jitter DDJ might be determined by taking the difference between this measurement and the measurement above, wherein only bits with the same history are measured.

For measuring jitter characteristics without data dependent jitter, i.e. without any bit history influence, it is possible to provide a data signal with a repetitive bit sequence and to repetitively trigger this signal each at the same positions relative to each bit sequence. As this method only allows for only one measurement per repetition, the overall measurement time will increase with the length of the bit sequence. As it is often necessary or at least desirable to have short test times, this method only allows for short bit sequences, e.g. a Pseudo Random Bit Sequence PRBS with a degree of 15 bit corresponding to an example above-described.

The influence of previous bits to an actual bit might result from low pass characteristics of the DUT circuitry, e.g. internal transmission lines, amplifier output stages, etc. Depending on the lengths, specific characteristics of the transmission line, and the data speed, such influence is limited in time, or in other words, only a limited number of previous bits will have effects on an actual data signal value.

Therefore, in a further embodiment, the data signal is analyzed with respect to a depth of influence of previous bits to an actual bit, or in other words with respect to the influence of the bit history. This depth of influence can be denoted as number of preceding bits. For determining non data dependent jitter, the data signal will be triggered at a plurality of transitions having the same limited bit history, e.g. having the same preceding m-bit sequence, wherein m denotes the depth of influence. This allows for using long repetitive test patterns without increasing the test time. Further this allows for using non-repetitive data signals.

Alternatively, the analog sampling might be performed at timing points not being related to the data content (i.e. the bit sequence) of the data signal, preferably at equidistant time points, whereby the distance might be chosen to greater or equal the conversion time of the analog-to-digital converter(s) (e.g. a distance of 200 bit cycles of the data signal). The corresponding first sample values V1 and V2 and second sample values B1, B2, B3,..., are stored with relation to each other in or by the analyzing circuit 50. In a post processing, the first sample values are sorted with respect to their bit history into different bins.

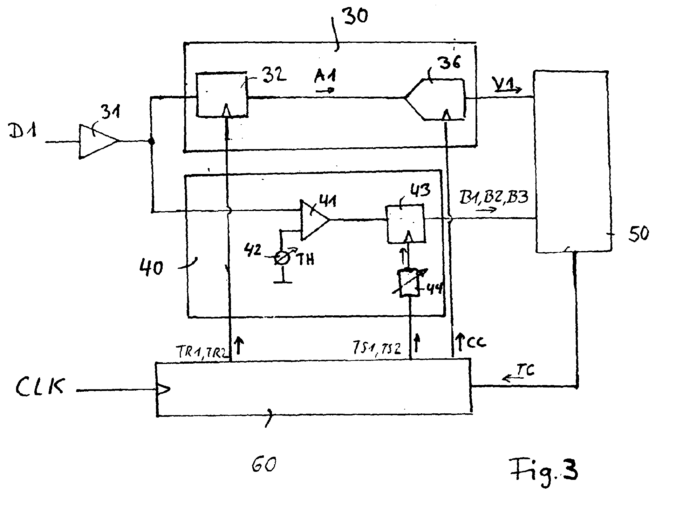

Fig. 3 shows a block diagram of a signal analyzer comprising an input buffer 31 and providing an input data signal D1 to an analog sampling path 30 and a digital sampling path 40. The analog sampling path 30 comprises a first sample&hold circuit 32, further also referred to as analog value sample&hold circuit 32 and an analog-to digital converter 33. The output of the sample&hold circuit 32 is connected to the input of the analog-to digital converter 36. The output of the analog-to digital converter 33 is connected to a first input of a signal analyzing circuit 50. Further, a trigger circuit 60 is provided that receives a clock signal CLK from a source not shown here, e.g. provided by a data source providing a digital data signal D1 recovered form the data signal D1 or being generated by an independent claock , and an trigger control signals TC from the analyzing circuit 50. The trigger circuit 60 provides a first trigger pulse TR1 to the trigger input of the sample&hold circuit 32 and further provides a converter trigger pulse or control signal CC to the analog-to-digital converter 33, whereby the time distance between those trigger signals is selected according to capabilities of holding a captured value over time of the sample&hold circuit 32.

The data signal D1 to be analyzed is provided to the input buffer 31 that provides a correspondingly buffered signal to the data input of the sample&hold circuit 32 that samples the actual data signal value A1 at the time point of receiving the first trigger pulse TR1. This analog value, that might be represented as an analog voltage within a certain voltage range is kept stored for a certain amount of time. The analog-to digital converter 33 converts the received analog value into a multi-bit digital value, e.g. being represented as 12 bit data or 16 bit data V1. This digital data value is provided to the analyzing circuit 50 for further edge fitting as described above.

The analyzing circuit 50 keeps stored one or a plurality of edge models for characterizing a signal edge, e.g. rising edge or a falling edge between the digital magnitude levels of the data signal. The edge model describes the expected signal value over the time of the data signal D1. Fitting said edge model to the detected signal value, the difference in magnitude between said detected signal value and predefined signal value, wherein by way of example the predefined signal value is the center values at a 50% level between the "low" bit signal level and a "high" bit signal level, is transformed into a time difference value. By relating the time difference value to the clock signal, the exact position of the signal edge can be determined.

Further, a digital sampling path 40, also being referred to as bit history determination path, is provided for taking a plurality of second sample values from the data signal D1 at a plurality of subsequent digital path trigger time points TD1-TD3, whereby these trigger points are preferably placed at equidistant time points within each the bit center of the data signal, i.e. these trigger points being placed in the center of the data eye.

Therefore, the analyzing circuit further comprises a comparator 41, a tunable threshold voltage source 42, a sampling flip flop (or digital sample&hold circuit) 43, and a tunable time delay circuit 44. A first input of the comparator 41 is connected to the buffer 32 for receiving the (buffered) data signal D1, whereas a second input of the comparator 41 is connected to the tunable threshold voltage source 42 that provides a tunable threshold voltage TH to said input. The output of the comparator 41 is connected to the data input of the sampling flip flop 43. The output of the sampling flip flop 43 is provided to the data analyzing circuit 50. The trigger input of said sampling flip flop 43 is connected to the tunable time delay circuit 44 that receives the clock signal CLK and provides a correspondingly delayed clock signal to the trigger input of the sampling flip flop 43. The clock signal CLK is preferably delayed such that the digital path trigger points are placed in the center of the data eye of the digital data signal D1.

The comparator 41 compares the digital data signal D1 with a constant threshold TH (e.g. the mean between the low signal level representing a bit value of "0" and the high signal level representing a bit value of "1", also being referred to as 50% level), or a dynamic threshold as e.g. applied in so-called decision feedback equalization (DFE). The comparator 41 generates a first value (e.g. a low voltage level), if the corresponding comparison value is below the threshold and a second value (e.g. a high voltage level"1", if the comparison value is above the threshold TH.

The sampling flip flop 43 samples the comparison result each at the digital path trigger points and assigns digital time discrete comparison results B1-B3 that are provided as bit stream to the analyzing circuit 50.

In an embodiment, the analyzing circuit 50 might continuously analyze the received bit stream B1, B2, B3 for detecting a predefined bit sequence within this bit stream. As soon as such predefined bit stream is detected, the analyzing circuit 50 generates a feed-back information FI to the trigger circuit 60. The trigger circuit 60 then provides a trigger pulse TR1 at the next possible signal transition. The correspondingly derived digital values V1 all have the same defined bit history. If such values are collected a plurality of times and corresponding time delays are superimposed as e.g. described above under Fig.2c, non data dependent jitter might be determined, provided that the length of the bit history is long enough to cover for history influences. The number of bits to be part of the bit history might be a fixed number or a selectable number being selected by the user.

Alternatively, the sampling might be performed at random timing points, whereby the first sample values (representing the actual edge value) and the second sample values (representing the bits of the data signal) are stored with relation to each other. In a post processing the first sample values are sorted with respect to a certain number of preceding bits into different bins.

In a further embodiment, the signal analyzer automatically determines the number of bits according to the history characteristics of the data signal D1.

In order to determine a number of preceding subsequent bits influencing an actual transition, i.e. to determine a depth of influence of previous bits to an actual transition, the analyzer is adapted for continuously determining transition values V1 of all bit transitions or a subset of bit transitions (e.g. all rising edges within one test sequence) of the data signal D1). At the same time the digital bit sequence B1, B2, B3 being received from the sample flip flop 43 is received and related to the transition values V1. The analyzing circuit 50 might then (in a post processing step) assign to each sample value V1 being sampled in the analog path a defined number of preceding bits B1, B2, B3, being sampled in the digital path.

Alternatively, if the bit sequence of the data signal D1 is known, or in other words, if the data signal D1 is known in principle, such sequence might be assigned to the sampled values V1 directly without digital sampling.

Further alternatively the sampled digital sequence might be used for synchronizing, i.e. for detecting a match of the sampled digital sequence with a sequence part of the known data signal D1, and performing a time relation with the analog sampling circuit. Therefore the analyzing circuit 50 might provide trigger control signals TC to the trigger circuit 60.

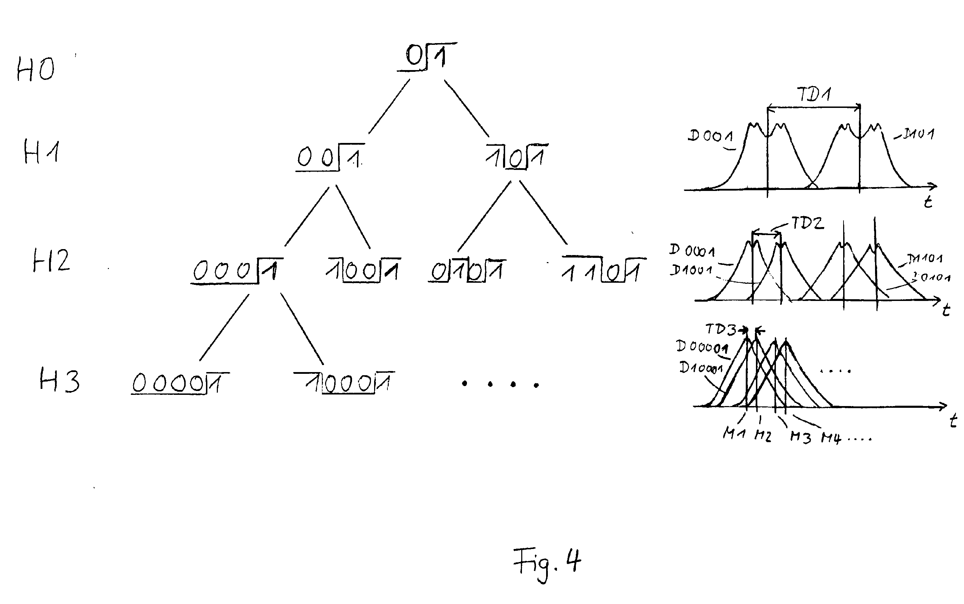

Fig.4 shows a principle scheme for determining the number of bits being relevant as bit history. In the first row H0 on the left side, a bit sequence of two bits "01" showing a transition with a rising edge, i.e. a transition from "0" to "1" is shown. In the second row, also being referred to as first history level H1, on the left side, 2 bit sequences of three bits, "001" and "101" are shown. The first sequence "001" of this level equals the sequence "01" of the row above together with a preceding bit "0". The second sequence "101" of this level equals the sequence "01" of the row above together with a preceding bit "1". On the right side of this level, for each of these sequences, a distribution of edge times D001 and D101 with respect to a clock signal as result of a plurality on measurements is shown. The difference of the mean values of both distributions D001 and D101 is depicted as first time distance TD1. This time distance indicates the dependency of first preceding bit on the edge timing of the data signal D1.

In the third row, also being referred to as second history level H2, on the left side, 4 bit sequences of four bits, "0001", "1001", "0101" and "1101" are shown. The first sequence "0001" of this level equals the first sequence "001" of the row above together with a preceding bit "0". The second sequence "1001" of this level equals the sequence "001" of the row above together with a preceding bit "1". The third sequence "0101" of this level equals the second sequence "101" of the row above together with a preceding bit "0". The fourth sequence "1101" of this level equals the second sequence "101" of the row above together with a preceding bit "1". On the right side of this level, distributions D0001, D1001, D0101 and D1101 of the edge times for the four different histories with respect to a reference signal as result of a plurality on measurements are shown. The difference of the mean values of the distributions D0001 and D1001 is depicted as second time distance TD2. This time difference indicates the dependency of the second preceding bit on the edge timing of the data signal D1. As qualitatively depicted this time distance TD2 is smaller than the first time distance TD1. For completeness reason, it is mentioned that the same measurement of time difference might be carried out for the third and the fourth sequence.

In the fourth row, also being referred to as third history level H3, on the left side, exemplary 2 bit sequences out of 8 sequences comprising 5 bits, "00001", "10001" are shown. The first sequence "00001" of this level equals the first sequence "0001" of the row above together with a preceding bit "0". The second sequence "10001" of this level equals the first sequence "0001" of the row above together with a preceding bit "1". On the right side of this level, exemplary for the shown first two sequences of this row, the first four distributions D00001 D10001, D01001, and D11001, of the edge times for the corresponding histories with respect to a time reference as result of a plurality on measurements are shown. The difference of the mean values of both distributions is depicted as third time distance TD3. This time difference indicates the dependency of the third preceding bit on the edge timing of the data signal D1. As qualitatively depicted this time distance TD3 is smaller than the second time distance TD2. Again for completeness reason, it is mentioned that the same measurement of time difference might be carried out for the third and the fourth, the fifth and sixth, and the seventh and eighth sequence not shown here.

As result of the history separation of the fourth history level, mean edge times M1, M2, M3, M4,.., are obtained as mean values of the corresponding edge time distributions.

A simple algorithm for determining the depth of bit history might thus proceed as follows:

In a first measurement run, a certain number of transitions measurements (e.g. 1024 samples) are performed. The corresponding timing results are sorted in separate bins in dependence of their bit history. On the first history level, the timing results are binned in dependence of the value of the first preceding bit. Therewith, the measured samples are sorted into two bins 001 and 101. For each bin, the mean values of the distributions are determined and the corresponding first time distance TD1 is compared with a predefined (sufficiently small) maximum time. If the first time distance TD1 does not exceed the predefined maximum time, the depth of influence is expected to be one bit. Otherwise, if the first time distance TD1 exceeds the predefined maximum time, the timing results are sorted into four bins 0001, 1001, 0101 and 1101 of the second history level H2. Again, the second time distance TD2 between two mean values (e.g. the mean values of the bins 0001, 1001) originating from one bin of the above level (e.g. bin 001), (and/or from the mean values of the bins 0101 and 1101) of this level is compared with the predefined maximum time. If the second time distance TD2 now does not exceed the predefined maximum time, the depth of influence is expected to be two bit. Otherwise this algorithm is continued in the same manner for further history levels.

Due to the limited number of measurement obtained the first run, the number of bins for sorting the measurement values is limited, because a sufficient number of results is necessary for obtaining relevant distributions for the corresponding edge timings. (E.g. for 1024 measurement values, the algorithm might stop at the third history level, wherein each bin will have 128 measurement values at average.) If the corresponding time difference is found to exceed the predefined maximum time at a certain history level (e.g. the third history level H2 for 1024 values), another set of measurements might be obtained in a second measurement run (e.g. again 1024 measurement values) in order to provide a sufficient number of values for further sorting. The second measurement run can be carried out in parallel to the (post-processing) history level evaluation algorithm.

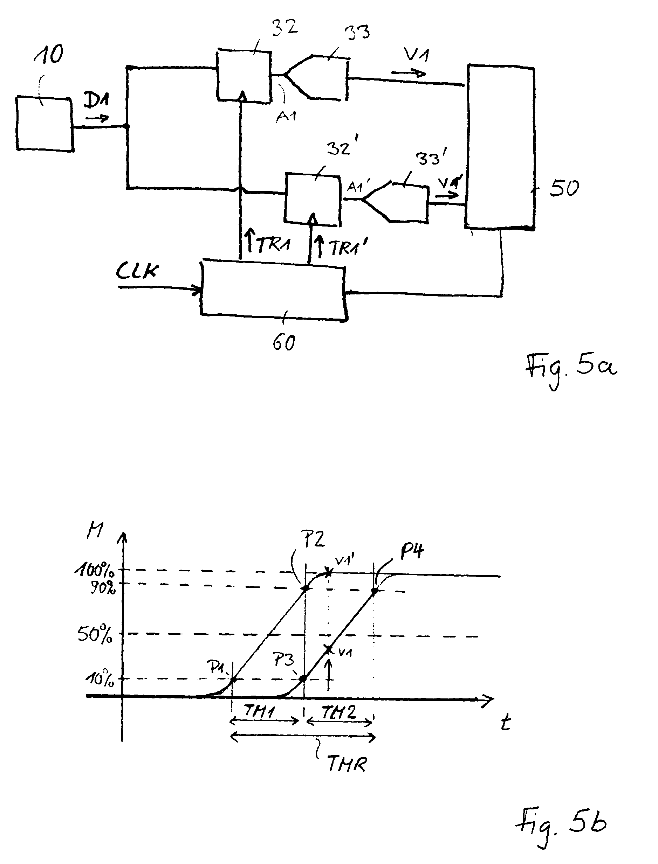

As described above, the trigger time points must be chosen such that the signal is sampled within its transition areas. In order to enhance the corresponding trigger time range, a filter showing a linear phase response might be connected between a data input and a corresponding sampling circuit. This filter decreases the (absolute) gradient of the signal edges without influencing further timing characteristics, e.g. the jitter properties, of the data signal. An alternative extension of the measurement or trigger time range that might be applied instead of such filter or in combination with such filter is described in Fig.5a.

Fig.5a shows a block diagram of a signal analyzer with an enhanced measurement range according to a further embodiment of the invention. By way of example, the signal analyzer shows a first and a second sample&hold circuit 32 and 32' with its outputs being connected to the input of each an analog-to digital converter 33 and 33' respectively. The outputs of the analog-to digital converters 33 and 33' are connected to a signal analyzing circuit 55.

Further, a trigger circuit 60 is provided that receives a clock signal CLK from a source, e.g. from the DUT 10 or any clock having the same frequency as the DUT or any frequency related to the data signal D1. The trigger circuit 60 provides a first trigger pulse TR1 and a shifted trigger pulse TR1' to the trigger input of the first sample&hold circuit 32 and to the trigger input of the second sample&hold circuit 32' respectively. Not shown here, the trigger circuit further provides a corresponding converter trigger signal to the analog-to-digital converters 33 as described in the above figure.

The data signal D1 is provided (e.g. over an input buffer not shown here) in parallel to both the inputs of the first and a second sample&hold circuit 32 and 32'.that sample the actual data signal values A1 and A1' at the time points when receiving the first trigger pulse TR1 and the second trigger pulse TR1' respectively, whereby the time distance between both trigger signal is determined to be equal or shorter than the transition duration. The analog-to digital converters convert the received analog values A1 and A1' into digital value V1 and V1'. This digital data value is provided to the analyzing circuit 50 for further edge fitting. Therefore, the analyzing circuit 50 keeps stored one or a plurality of edge models, e.g. a rising edge models characterizing the rising edge and a falling edge model characterizing the falling edge. The edge models describe the expected signal value over the time of the respective data signal D1.

The analyzing circuit 50 selects one of the received digital values V1 and V1' and performs an edge time determination by fitting the selected digital value V1 or V1' to an edge model, thereby transforming a difference in magnitude between said detected signal value and a predefined signal value into a time difference values as described above.

The trigger circuit 60 generates the trigger pulses TR1 and TR1' with respect to the clock signal CLK at a defined distance to each other. The distance is preferably chosen to be equal to a measurement or trigger time range of a single transition. Fig.5b shows an example, wherein two signal edges are depicted at the trigger time distance TR1'-TR1. This time distance is chosen to be equal to the measurement range TM1 or TM2 of the transition. In the example shown here, the measurement range is chosen as time interval between each a 10% point P1 of the signal amplitude (i.e. the difference between the high level and the low level) and a 90% point P2 of the signal amplitude or between corresponding points P3 and P4 of the delayed transition correspondingly. This allows for multiplying the resulting measurement range TMR by two. Providing further additional sample&hold circuits connected in parallel to the first and a second sample&hold circuit 32 and 32' allows for extending the resulting measurement range corresponding to the number of the sample&hold circuits.

As consequence, there will be only one of the values V1 or V1' that can be used for edge fitting whereby the other value will have the high level value or low level value or a value close to these values. In the example shown here, the first sample&hold circuit 32 derives a sample value V1 of roughly 40% of the signal amplitude, whereas the value V1' derived from the delayed measurement by the second sample&hold circuit32' shows almost the maximum level. Whereas the first value V1 can be well used for an edge fitting, the value V1' cannot be used for such edge fitting. Therefore, before the edge fitting, the analyzing circuit might chose the most significant value (i.e. the value that is not close or equal to the low or high signal level or the value that refers to the higher absolute gradient of the signal edge).

Alternatively, the signal analyzer might comprise a first and a second sampling path comprising each one sample&hold circuit and one switchable transfer gate. The transfer gates are alternately triggered in order to alternately provide the first sampled value and the second sampled value to one analog-to-digital converter. Similarly to the previous embodiment, the analyzing circuit receives the analog values V1 and V1' for further processing.

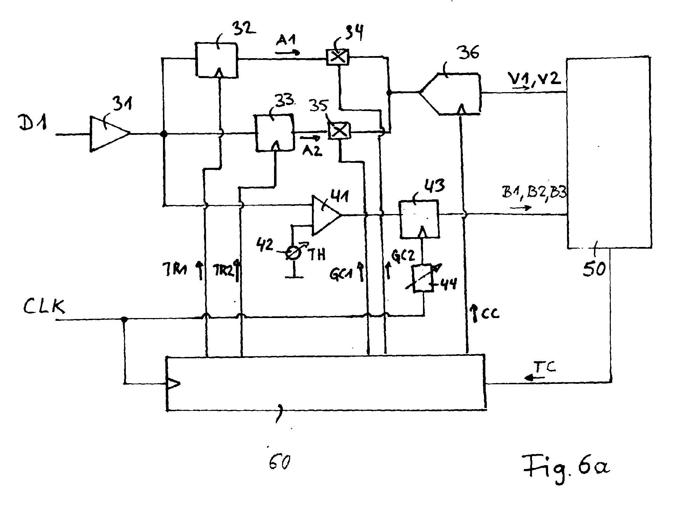

Fig. 6a shows a more detailed block diagram of a time interval analyzer 2 and 2' according to Fig. 1a or Fig.1b representing an analyzer with an enhanced analog sampling circuit with respect to the signal analyzer of Fig.3. The analog sampling circuit comprises a first and a second sample&hold circuit 32 and 33 with its outputs being connected over each a first and second transfer gate 34 and 35 to the input of an analog-to digital converter 36. The data signal D1 is provided to an input of a buffer 31, that is connected to the inputs of both the first and a second sample&hold circuit 32 and 33.

Similar to the analyzer of Fig.3, the time interval analyzer comprises a digital sampling circuit for determining a bit history, the digital sampling circuit further comprising a comparator 41, a tunable threshold voltage source 42, a sampling flip flop 43, a tunable time delay circuit 44 and an analyzing circuit 50.

The data signal D1 is provided to a first input of the comparator 41. A second input of the comparator 41 is connected to the tunable threshold voltage source 42 that provides a tunable threshold voltage TH to said input. The output of the comparator 41 is connected to the data input of the sampling flip flop 43. The output of the sampling flip flop 43 is provided to the analyzing circuit 50. The trigger input of said sampling flip-flop 43 is connected to the tunable time delay circuit 44 that receives the clock signal CLK and provides a corresponding tuned trigger signal to the sampling flip flop 43.

The digital sampling circuit measures the position is determined by a relative time set by the delay circuit 44 with respect to corresponding transition of the clock signal CLK and the threshold value TH.

A trigger circuit 60 receiving the clock signal CLK provides a first trigger pulse TR1 to the first sample&hold circuit 32, a second trigger pulse TR2 to the second sample&hold circuit 33, a first and a second gate trigger or control signal SG1 and SG2 provided to the control input of the first and second transfer gate 34 and 35 respectively and a converter control signal CC to the analog-to-digital converter 36.

As being described previously, the analog sampling might be performed at timing points not being related to the data content of the data signal, The corresponding first sample values V1 and V2 and second sample values B1, B2, B3,..., are stored with relation to each other in or by the analyzing circuit 50. In a post processing, the first sample values are sorted with respect to a certain bit history into different bins.

In order to derive non-data dependent jitter characteristics, only time difference values of one pairs of bins might be used for the time interval analysis.

In a further embodiment, the relevant number of history bits might be derived my means of an algorithm described under Fig.4.

. The number of bits to be part of the transition history might be a fixed number or a selectable number being selected by the user or being automatically determined by the analyzer.

In order to determine a number of preceding subsequent bits influencing an actual transition the trigger circuit similar to Fig.3 might be adapted for continuously determining transition values V1 of all bit transitions or a subset of bit transitions (e.g. all rising edges within one test sequence) of the data signal D1. At the same time the digital bit sequence B1, B2, B3 being received from the sample flip flop 43 is received and related to the transition values V1. The analyzing circuit 50 might then assign to each first sample value V1 being sampled by the analog sampling circuit path a defined number of preceding bits B1, B2, B3, being sampled in the digital sampling circuit.

In a further embodiment, the signal analyzer automatically determines the number of bits according to the history characteristics of the data signal D1 as described under Fig.4.

If the bit sequence of the data signal D1 is known, or in other words, if the data signal D1 is known in principle, such sequence might be assigned to the sampled values V1 directly without digital sampling. In this case it is sufficient to digitally sample at specific times in order to synchronize to the data signal D1.

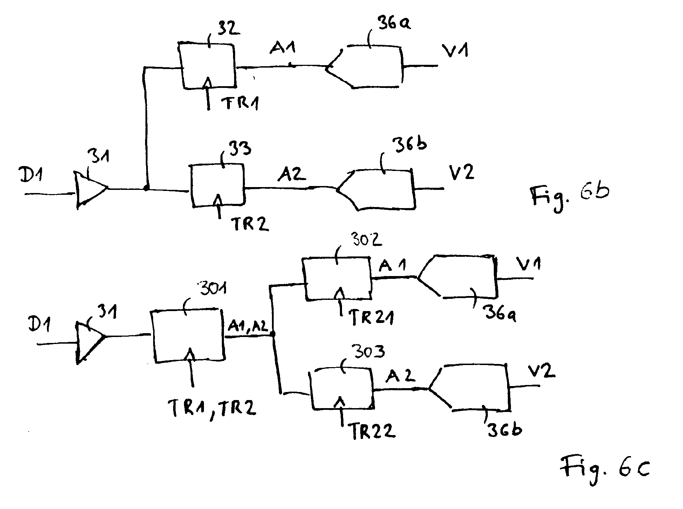

Fig. 6b shows a variant of Fig.6a comprising two analog-to digital converters 36a and 36b each connected to one of the sample and hold circuits 32 and 33. It is therefore not necessary to provide any transfer gate 34 or 35 to alternately provide the first signal sample A1 and the second signal sample A2 to a converter circuit. This allows for processing higher speed data as the two converter circuits work in parallel. Further, the accuracy is increased, as no transfer gates are comprised that could introduce errors.

Fig.6c shows a variant of Fig.6b with a sampling circuit comprising a first sample&hold circuit 301 being arranged to receive the first trigger pulse TR1 and the second trigger pulse TR2 at its trigger input and the data signal D1 at its signal input, and exemplarily a second and a third sample&hold circuit 302 and 303 each receiving at their signal inputs a signal output from the first sample&hold circuit 301 The trigger circuit 60 alternately provides a third and a forth trigger pulse TR21 andTR22 to each one of the trigger inputs of said third and fourth sample&hold circuit 302 and303.

High bandwidth first sample&hold circuits allow for precise sampling with little signal deterioration. However, such high bandwidth sample&hold circuits may have short hold times. In this embodiment, only one sample&hold circuit 301 need to have highest bandwidth, whereas sample&hold circuit 302 and 303 might show lower bandwidths, and can be optimized for longer hold times. As a further advantage, the input signal has a smaller load impact compared to the above embodiment.

Further, as two analog-to-digital converters 36a and 36b are comprised, they might have a lower frequency (i.e. a lower conversion rate) with respect to the one analog-to-digital converter 36 of Fig.6a, or the circuit might process twice as many samples.

In a further embodiment, additional sample&hold circuits connected in parallel to the sample&hold circuits 302 and 303 are provided further allowing to reduce the conversion rates of the corresponding analog-to-digital converters, or to increase the processing rate correspondingly.

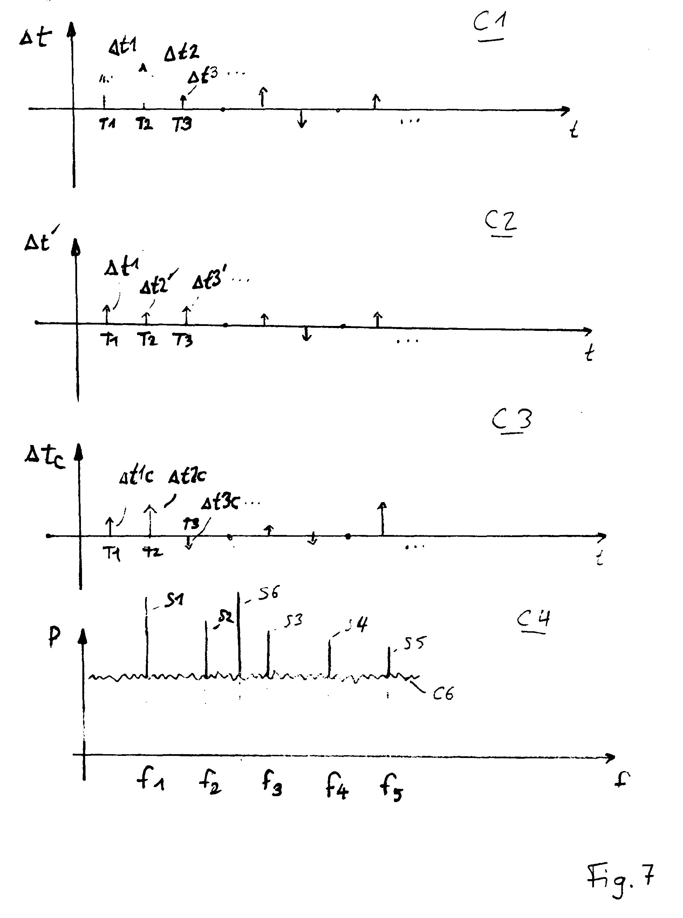

Fig.7 shows schematic diagrams describing a jitter separation with bit history consideration that might be performed in signal analyzers 50 of Fig.1a, Fig1b, Fig.3, or Fig.6a.

In a first diagram C1, time difference values Δt1, Δt2, Δt3 are obtained from sample values at subsequent time points T1, T2, T3 in transition areas of the data signal D1. The values are obtained for transitions with different bit histories. Therefore, a jitter analysis of these values will include data dependent jitter.

In a second diagram C2, mean time difference values Δt1', Δt2', Δt3' are depicted that relate to the mean time differences M1, M2, M3,..., .(e.g. obtained by a measurement according to Fig.4) related to the different bit histories of the sampled values.

In a third diagram C3, adjusted difference values Δt1c, Δt2c, Δt3c are depicted that result from taking the differences Δt1 - Δt1', Δt2- Δt2', Δt3- Δt3' between each the time differences values and the mean time difference values. A jitter analysis of these values will not comprise data dependent jitter, but still comprises random jitter and periodic jitter.

For further decomposition, a Discrete Fourier Transition, preferably a Fast Fourier Transformation of the adjusted time difference values Δt1c, Δt2c, Δt3c might be performed, thereby obtaining a power density spectrum P over the frequency f. If periodic jitter is present, this spectrum will show one or more distinct frequency lines.

Providing a spectral jitter analysis the jitter components can be detected, e.g. the periodic jitter component can be derived by transforming the identified one or more distinct spectral components into the time domain.

C4 shows an exemplary of power density spectrum derived from a Discrete Fourier Transformation of the adjusted time difference values Δt1c, Δt2c, Δt3c, thereby obtaining a power density spectrum P comprising by way of example peak frequencies S1- S6 referring to periodic jitter and roughly constant function over the frequency C6 referring to random jitter. By way of example, the frequency peaks S1- S5 are equidistantly spaced at exemplary frequencies f1- f5.

Instead of analyzing a single ended ground referenced signal D1, this signal might be received as a differential signal being transmitted over a differential line. The differential signal might de terminated by an input buffer that generates a ground referenced signal out of the differential signal. Alternatively, the input buffer, sample&hold circuit(s), and/or the analog-to-digital converter(s) of the above embodiments might be realized as differential signal circuits.

## Claims

1. A time interval analyzer (2, 2', 6) for determining timing characteristics of one or more data signals (D1) comprising a bit sequence of a plurality of bits, comprising:
a control circuit (60) adapted for generating a first trigger signal with a first trigger pulse (TR1) at a first trigger time (T1) within a region of a first signal transition (E1, E3) and a second trigger pulse (TR2) at a second trigger time (T2) within a region of a second signal transition (E2, E4),
a sampling circuit (21, 30) adapted for receiving the first trigger signal (TR1, TR2), and taking a first sample value (A1) and a second sample value (A2) from the one or more data signals (D1) at said first and second trigger times respectively (T1, T2), and
an analyzing circuit (50) adapted for storing an edge model (EM1, EM2) of signal edges (E1, E2, E3, E4) of the one or more data signals (D1) describing the signal magnitude over the time,
**characterized in that** the analyzing circuit (50) is further adapted for determining from said edge model a first time difference (Δt1) between the first sample value (A1) and a defined transition value and a second time difference (Δt2) between the second sample value (A2) and the defined transition value, and providing a time interval analysis on the base of the second time difference (Δt2) and the first time difference (Δt1).

2. The time interval analyzer (2, 2', 6) of claim 1, wherein the control circuit (60) is adapted to generate the trigger pulses (TR1, TR2) relative to the clock signal (CLK), the analyzer thereby being adapted for one of:
• receiving the clock signal (CLK) separately from one of the one or more data signals (D1),
• recovering the clock signal (CLK) from one of the one or more data signals (D1) by means of a clock recovery circuit (24), and
• deriving the clock signal (CLK) from an internal clock having a defined frequency relation with respect to the data rate of one of the one or more data signals (D1).

3. The time interval analyzer (2, 2', 6) of claim 1, or any one of the above claims, further being adapted for determining a time interval (TM1, TM2) between the first signal edge (E1, E3) and the second signal edge (E2, E4) by taking the difference between the trigger times (T1, T2) and a resulting time difference (ΔT) between the second time difference (Δt2), and the first time difference (Δt1).

4. The time interval analyzer (2, 2', 6) of claim 2 or any one of the above claims, further being adapted for repeating the determination of the first and second time differences (Δt1, Δt2) for a plurality of time intervals (T, nT) within the one or more data signals (D1), and determining jitter characteristics on the base of variations of the first and second time differences (Δt1, Δt2) or of variations of time differences resulting from said first and second time differences (Δt1, Δt2).

5. The time interval analyzer (2, 2', 6) of claim 4, wherein the jitter characteristics are derived from at least one of:
• mean values of the distribution functions over the time of each the first of the first and second time differences (Δt1, Δt2),
• minimum and maximum values of a distribution function over the resulting time difference (ΔT) of the second time difference (Δt2) and the first time difference (Δt1).

6. The time interval analyzer (2, 2', 6) of claim 1 or any one of the above claims, wherein the sampling circuit (21) provides the sample values (A1, A2) as analog values, preferably voltage values, the analyzer further comprising a converter circuit (23) adapted for converting the first sample value (A1) and the second sample value (A2) into a first multi-bit digital value (V1) and a second multi-bit digital value (V2), and the analyzing circuit (50) being adapted for storing the edge model as a plurality of digital values or as an algorithm providing digital values.

7. The time interval analyzer (2, 2', 6) of claim 6, wherein the sampling circuit (21) comprises a first sample&hold circuit (32) being arranged to receive the first trigger pulse (TR1) at its trigger input and one of the one or more data signals (D1) at its signal input, and a second sample&hold circuit (33), being arranged to receive the second trigger pulse (TR2) at its trigger input and said one of the one ore more data signals (D1) or another one of the ore more data signals at its signal input.

8. The time interval analyzer (2, 2', 6) of claim 7, comprising at least one of:
• the signal outputs of the first and second sample&hold circuits (32, 33) are connected each over a first and a second transfer gate (34, 35) to the converter circuit (23), and wherein the control circuit (60) is adapted to provide gate control signals (GC1, GC2) such that the first and a second transfer gate (34, 35) alternately provide the first sample value (A1) and the second sample value (A2) respectively to the converter circuit (23, 36);
• a first and a second converter circuit (36a, 36b) wherein the first sample&hold circuit (32) is adapted to provide the first sample value (A1) to the first converter circuit (36a), and the second sample&hold circuit (33) is adapted to provide the second sample value (A2) to the second converter circuit (36b);
• the sampling circuit (21) comprises a first sample&hold circuit (301) being arranged to receive the first trigger pulse (TR1) and the second trigger pulse (TR2) at its trigger input and the data signal (D1) at its signal input, and two further sample&hold circuit (302, 303) adapted to each receive at their signal inputs a signal output from the first sample&hold circuit (301), and wherein the control circuit (60) is adapted to alternately provide a third and a forth trigger pulse (TR21, TR22) to each one of the trigger inputs of said further sample&hold circuit (302, 303).

9. The time interval analyzer (2, 2', 6) of claim 1 or any one of the above claims, wherein the defined signal value represents one of: the geometric center with respect to time of the edge model (EM1, EM2), the geometric center with respect to magnitude of the edge model (EM 1, EM2) and the most likely transition point.

10. The time interval analyzer (2, 2', 6) of claim 1 or any one of the above claims, wherein the edge model (EM1, EM2) represents one of:
• a polynomial best fit curve of a measured signal edge (E1, E2, E3, E4),
• a section-wise curve composed of one or more linear or polynomial sections, fitted to measured signal edge (E1, E2, E3, E4),
• a curve composed of a plurality of measured edge curves (E1, E2, E3, E4),

11. The time interval analyzer (2, 2', 6) of the preceding claim, wherein the edge model (EM1, EM2) is stored as one of:
• mathematical formula or algorithm producing a time value out of an signal value,
• a table comprising a plurality of pairs of curve values and time values of said edge model (EM1, EM2).

12. The time interval analyzer (2, 2', 6) of claim 1 or any one of the above claims, comprising at least one of:
• the time interval analyzer is further adapted for repetitively sampling the one or more data signals (D1) at a plurality of subsequent trigger time points, with respect to a signal transition such that the trigger time points are shifted over the transition, and further being adapted to derive the edge model (EM1, EM2) from the corresponding sampled values;
• a filter being connected between a data input and the sampling circuit (21) for decreasing the slope of the signal edges (E1, E2, E3, E4);
• a second sampling circuit (40) adapted for comparing the data signal (D1) with a threshold (VTH) and assigning, in response to a second signal trigger signal (TS1, TS2), bit values (B1, B2, B3) depending on corresponding comparison results, wherein the analyzing circuit (50) adapted for assigning to each time interval (TM1, TM2) a defined number of subsequent bit values (B1, B2, B3), wherein a set of subsequent bits represents at least partly a bit history being occurred in advance to the time interval.

13. The time interval analyzer (1) of claim 5, that is adapted for sorting the time intervals (TM1, TM2) according to each their bit history, into a plurality of different groups, each group being related to a unique sequence of a defined number forming a unique bit history.

14. The time interval analyzer (1) of the preceding claim, further being adapted for analyzing the data signal (D1) in order to determine a depth of influence of previous bits to an actual bit, and to determine the number of bits of the bit history.

15. A method of determining time characteristics of one or more data signals (D1) comprising a sequence of a plurality of bits, comprising:
providing a first sample value (A1) at a first time (T1) within a region of a first signal transition (E1, E3) and providing a second sample value (A2) at a second time (T2) within a region of a second signal transition (E2, E4) of the one or more data signals (D1),
retrieving an edge model (EM1, EM2) of the signal edges (E1, E2, E3, E4) describing the signal magnitude over the time of the data signal (D1),
**characterized by**
determining from said edge model a first time difference (Δt1) between the first sample value (A1) and a defined signal value and a second time difference (Δt2) between the second sample value (A2) and the defined value, and
determining the timing characteristics on the base of the second time difference (Δt2) and the first time difference (Δt1).

16. A software program or product, preferably stored on a data carrier, for executing all the steps of the method of claim 15, when run on a data processing system such as a computer.

## Patentansprüche

1. Zeitintervall-Analysator (2, 2', 6) zum Ermitteln des Zeitverhaltens eines oder mehrerer Datensignale (D1), die eine Bitfolge aus einer Vielzahl von Bits aufweisen, wobei der Zeitintervall-Analysator Folgendes aufweist:
eine Steuerschaltung (60) zum Erzeugen eines ersten Auslösesignals mit einem ersten Auslöseimpuls (TR1) an einem ersten Auslösezeitpunkt (T1) innerhalb eines Bereichs einer ersten Signalflanke (E1, E3) und mit einem zweiten Auslöseimpuls (TR2) an einem zweiten Auslösezeitpunkt (T2) innerhalb einer zweiten Signalflanke (E2, E4),
eine Abtastschaltung (21, 30) zum Empfangen des ersten Auslösesignals (TR1, TR2) und zum Erfassen eines ersten Abtastwertes (A1) und eines zweiten Abtastwertes (A2) von dem einen oder den mehreren Datensignalen (D1) an dem ersten bzw. dem zweiten Auslösezeitpunkt (T1, T2), und
eine Analyseschaltung (50) zum Speichern eines Flankenmodells (EM1, EM2) der Signalflanken (E1, E2, E3, E4) des einen oder der mehreren Datensignale (D1), welches die Signalintensität im Verlauf der Zeit beschreibt,
**dadurch gekennzeichnet, dass** die Analyseschaltung (50) ferner in der Lage ist, aus dem Flankenmodell eine erste Zeitdifferenz (Δt1) zwischen dem ersten Abtastwert (A1) und einem definierten Übergangswert und eine zweite Zeitdifferenz (Δt2) zwischen dem zweiten Abtastwert (A2) und dem definierten Übergangswert zu ermitteln und auf der Grundlage der zweiten Zeitdifferenz (Δt2) und der ersten Zeitdifferenz (Δt1) eine Zeitintervallanalyse zu liefern.

2. Zeitintervall-Analysator (2, 2', 6) nach Anspruch 1, bei dem die Steuerschaltung (60) in der Lage ist, die Auslöseimpulse (TR1, TR2) in Bezug auf das Taktsignal (CLK) zu erzeugen, wodurch der Analysator in der Lage ist, einen der folgenden Schritte auszuführen:
• Empfangen des Taktsignals (CLK) getrennt von dem einen oder den mehreren Datensignalen (D1),
• Wiederherstellen des Taktsignals (CLK) aus dem einen oder den mehreren Datensignalen (D1) unter Verwendung einer Taktwiederherstellungsschaltung (24), und
• Ableiten des Taktsignals (CLK) von einem internen Takt, der ein definiertes Frequenzverhältnis in Bezug auf die Datenrate entweder des einen oder der mehreren Datensignale (D1) aufweist.

3. Zeitintervall-Analysator (2, 2', 6) nach Anspruch 1 oder einem der obigen Ansprüche, der ferner in der Lage ist, unter Verwendung der Differenz zwischen den Auslösezeitpunkten (T1, T2) und einer sich ergebenden Zeitdifferenz (ΔT) zwischen der zweiten Zeitdifferenz (Δt2) und der ersten Zeitdifferenz (Δt1) ein Zeitintervall (TM1, TM2) zwischen der ersten Signalflanke (E1, E3) und der zweiten Signalflanke (E2, E4) zu ermitteln.

4. Zeitintervall-Analysator (2, 2', 6) nach Anspruch 2 oder einem der obigen Ansprüche, der ferner in der Lage ist, die Ermittlung der ersten und der zweiten Zeitdifferenz (Δt1, Δt2) für eine Vielzahl von Zeitintervallen (T, nT) innerhalb des einen oder der mehreren Datensignale (D1) zu wiederholen und Schwankungsmerkmale (jitter characteristics) auf der Grundlage der Veränderungen der ersten und der zweiten Zeitdifferenz (Δt1, Δt2) oder der Veränderungen der sich aus der ersten und der zweiten Zeitdifferenz (Δt1, Δt2) ergebenden Zeitdifferenzen zu ermitteln.

5. Zeitintervall-Analysator (2, 2', 6) nach Anspruch 4, bei dem die Schwankungsmerkmale aus mindestens einem der folgenden Werte ermittelt werden:
• aus den Mittelwerten der Verteilungsfunktionen als Funktion der Zeit jeder der ersten und der zweiten Zeitdifferenz (Δt1, Δt2),
• aus den Minimal- und Maximalwerten einer Verteilungsfunktion über die sich ergebende Zeitdifferenz (ΔT) der zweiten Zeitdifferenz (Δt2) und der ersten Zeitdifferenz (Δt1).

6. Zeitintervall-Analysator (2, 2',6) nach Anspruch 1 oder einem der obigen Ansprüche, bei dem die Abtastschaltung (21) die Abtastwerte (A1, A2) als Analogwerte, vorzugsweise als Spannungswerte, bereitstellt, wobei der Analysator ferner eine Umsetzerschaltung (23) zum Umsetzen des ersten Abtastwertes (A1) und des zweiten Abtastwertes (A2) in einen ersten digitalen Mehrbitwert (V1) und einen zweiten digitalen Mehrbitwert (V2) aufweist und die Analyseschaltung (50) in der Lage ist, das Flankenmodell in Form einer Vielzahl von digitalen Werten oder als Algorithmus zu speichern, der digitale Werte liefert.

7. Zeitintervall-Analysator (2, 2', 6) nach Anspruch 6, bei dem die Abtastschaltung (21) eine erste Abtast-Halte-Schaltung (sample&hold circuit) (32) zum Empfangen des ersten Auslöseimpulses (TR1) an seinem Auslösesignaleingang und des einen oder der mehreren Datensignale (D1) an seinem Datensignaleingang und eine zweite Abtast-Halte-Schaltung (33) zum Empfangen des zweiten Auslöseimpulses (TR2) an seinem Auslösesignaleingang und des einen oder der mehreren Datensignale (D1) oder weiterer Datensignale an seinem Datensignaleingang aufweist.

8. Zeitintervall-Analysator (2, 2', 6) nach Anspruch 7, der mindestens eines der folgenden Merkmale aufweist:
• die Signalausgänge der ersten und der zweiten Abtast-Halte-Schaltung (32, 33) sind jeweils über ein erstes und ein zweites Übertragungsgatter (34, 35) mit der Umsetzerschaltung (23) verbunden, wobei die Steuerschaltung (60) in der Lage ist, Gattersteuersignale (GC1, GC2) derart bereitzustellen, dass das erste und das zweite Übertragungsgatter (34, 35) abwechselnd den ersten Abtastwert (A1) bzw. den zweiten Abtastwert (A2) an die Umsetzerschaltung (23, 36) übertragen;
• eine erste und eine zweite Umsetzerschaltung (36a, 36b), wobei die erste Abtast-Halte-Schaltung (32) in der Lage ist, den ersten Abtastwert (A1) an die erste Umsetzerschaltung (36a) zu übertragen, und die zweite Abtast-Halte-Schaltung (33) in der Lage ist, den zweiten Abtastwert (A2) an die zweite Umsetzerschaltung (36b) zu übertragen;
• die Abtastschaltung (21) weist eine erste Abtast-Halte-Schaltung (301), die so angeordnet ist, dass sie den ersten Auslöseimpuls (TR1) und den zweiten Auslöseimpuls (TR2) an ihrem Auslösesignaleingang und das Datensignal (D1) an ihrem Datensignaleingang empfängt, und zwei weitere Abtast-Halte-Schaltungen (302, 303) auf, die in der Lage sind, an ihrem jeweiligen Signaleingang ein von der ersten Abtast-Halte-Schaltung (301) ausgegebenes Signal zu empfangen, wobei die Steuerschaltung (60) in der Lage ist, abwechselnd jeweils einen dritten und einen vierten Auslöseimpuls (TR1, TR2) an jeden der Auslösesignaleingänge der weiteren Abtast-Halte-Schaltungen (302, 303) zu übertragen.

9. Zeitintervall-Analysator (2, 2', 6) nach Anspruch 1 oder einem der obigen Ansprüche, bei dem der definierte Signalwert eines der folgenden Merkmale darstellt: den geometrischen Mittelpunkt in Bezug auf die Zeit des Flankenmodells (EM1, EM2), den geometrischen Mittelpunkt in Bezug auf die Intensität des Flankenmodells (EM1, EM2) und den wahrscheinlichsten Übergangspunkt.

10. Zeitintervall-Analysator (2, 2', 6) nach Anspruch 1 oder einem der obigen Ansprüche, bei dem das Flankenmodell (EM1, EM2) eines der folgenden Merkmale darstellt:
• eine polynomial angenäherte Kurve einer gemessenen Signalflanke (E1, E2, E3, E4),
• eine aus mehreren Abschnitten bestehende Kurve, die aus einem oder mehreren linearen oder Polynomaschnitten besteht und eine Näherung der gemessenen Signalflanke (E1, E2, E3, E4) darstellt,
• eine aus einer Vielzahl gemessener Flankenkurven (E1, E2, E3, E4) bestehende Kurve.

11. Zeitintervall-Analysator (2, 2', 6) nach dem vorhergehenden Anspruch, bei dem das Flankenmodell (EM1, EM2) in einer der folgenden Formen gespeichert ist:
• als mathematische Formel oder Algorithmus, die aus einem Signalwert einen Zeitwert erzeugen,
• eine Tabelle, die eine Vielzahl von Paaren aus Kurvenwerten und Zeitwerten des Flankenmodells (EM1, EM2) aufweist.

12. Zeitintervall-Analysator (2, 2', 6) nach Anspruch 1 oder einem der obigen Ansprüche, der mindestens eines der folgenden Merkmale aufweist:
• der Zeitintervall-Analysator ist ferner in der Lage, das eine oder die mehreren Datensignale (D1) wiederholt an einer Vielzahl aufeinander folgender Auslösezeitpunkte in Bezug auf einen Signalübergang abzutasten derart, dass die Auslösezeitpunkte über den Übergang verschoben werden, und ist ferner in der Lage, das Flankenmodell (EM1, EM2) von den entsprechenden Abtastwerten abzuleiten;
• ein Filter, das zur Verringerung des Anstiegs der Signalflanken (E1, E2, E3, E4) zwischen einen Dateneingang und die Abtastschaltung (21) geschaltet ist;
• eine zweite Abtastschaltung (40) zum Vergleichen des Datensignals (D1) mit einem Schwellenwert (VTH) und zum Zuweisen von Bitwerten (B1, B2, B3) als Reaktion auf ein zweites Auslösesignal (TS1, TS2) in Abhängigkeit von entsprechenden Vergleichsergebnissen, wobei die Analyseschaltung (50) in der Lage ist, jedem Zeitintervall (TM1, TM2) eine definierte Anzahl aufeinander folgender Bitwerte (B1, B2, B3) zuzuweisen, und wobei ein Satz aufeinander folgender Bits zumindest teilweise den Bitverlauf vor dem Zeitintervall darstellt.

13. Zeitintervall-Analysator (1) nach Anspruch 5, der in der Lage ist, die Zeitintervalle (TM1, TM2) jeweils entsprechend ihrem Bitverlauf nach einer Vielzahl verschiedener Gruppen zu sortieren, wobei sich jede Gruppe auf eine nur einmal vorkommende Folge einer definierten Anzahl bezieht, die einen nur einmal vorkommenden Bitverlauf bilden.

14. Zeitintervall-Analysator (1) nach Anspruch 1, der ferner in der Lage ist, das Datensignal (D1) zu analysieren, um eine Tiefe der Einflussnahme vorhergehender Bits auf ein aktuelles Bit und die Anzahl der Bits des Bitverlaufs zu ermitteln.

15. Verfahren zum Ermitteln des Zeitverhaltens eines oder mehrerer Datensignale (D1), die eine Folge einer Vielzahl von Bits aufweisen, wobei das Verfahren die folgenden Schritte aufweist:
Bereitstellen eines ersten Abtastwertes (A1) zu einem ersten Zeitpunkt (T1) innerhalb eines Bereichs einer ersten Signalflanke (E1, E3) und Bereitstellen eines zweiten Abtastwertes (A2) an einem zweiten Zeitpunkt (T2) innerhalb eines Bereichs einer zweiten Signalflanke (E2, E4) des einen oder der mehreren Datensignale (D1),
Abrufen eines Flankenmodells (EM1, EM2) der Signalflanken (E1, E2, E3, E4), das die Signalintensität des Datensignals (D1) als Funktion der Zeit beschreibt, **gekennzeichnet durch**
Ermitteln einer ersten Zeitdifferenz (Δt1) zwischen dem ersten Abtastwert (A1) und einem definierten Signalwert und einer zweiten Zeitdifferenz (Δt2) zwischen dem zweiten Abtastwert (A2) und dem definierten Wert aus dem Flankenmodell, und
Ermitteln des Zeitverhaltens auf der Grundlage der zweiten Zeitdifferenz (Δt2) und der ersten Zeitdifferenz (Δt1).

16. Softwareprogramm oder -produkt, das vorzugsweise auf einem Datenträger gespeichert ist, zum Ausführen aller Schritte des Verfahrens nach Anspruch 15, wenn dieses auf einem Datenverarbeitungssystem wie beispielsweise einem Computer ausgeführt wird.

## Revendications

1. Analyseur d'intervalle de temps (2, 2', 6) pour déterminer des caractéristiques de temporisation d'un ou de plusieurs signaux de données (D1) comprenant une séquence de bits d'une pluralité de bits, comprenant :
un circuit de commande (60) à même de générer un premier signal de déclenchement avec une première impulsion de déclenchement (TR1) à un premier temps de déclenchement (T1) dans une région d'une première transition entre signaux (E1, E3) et une deuxième impulsion de déclenchement (TR2) à un deuxième temps de déclenchement (T2) dans une région d'une deuxième transition entre signaux (E2, E4) ;
un circuit d'échantillonnage (21, 30) à même de recevoir le premier signal de déclenchement (TR1, TR2), et de tirer une première valeur d'échantillonnage (A1) et une deuxième valeur d'échantillonnage (A2) du ou des signaux de données (D1) respectivement auxdits premier et deuxième temps de déclenchement (T1, T2), et
un circuit d'analyse (50) à même de stocker un modèle de flanc (EM1, EM2) de flancs de signal (E1, E2, E3, E4) du ou des signaux de données (D1) décrivant l'intensité du signal dans le temps ;
**caractérisé en ce que** le circuit d'analyse (50) est en outre à même de déterminer à partir dudit modèle de flanc une première différence de temps (Δt1) entre la première valeur d'échantillonnage (A1) et une valeur de transition définie et une deuxième différence de temps (Δt2) entre la deuxième valeur d'échantillonnage (A2) et la valeur de transition définie, et de fournir une analyse d'intervalle de temps sur la base de la deuxième différence de temps (Δt2) et de la première différence de temps (Δt1).

2. Analyseur d'intervalle de temps (2, 2', 6) suivant la revendication 1, dans lequel le circuit de commande (60) est à même de générer les impulsions de déclenchement (TR1, TR2) par rapport au signal d'horloge (CLK), l'analyseur étant de ce fait à même d'exécuter l'une des étapes suivantes :
• recevoir le signal d'horloge (CLK) séparément d'un parmi le ou les signaux de données (D1) ;
• extraire le signal d'horloge (CLK) d'un parmi le ou les signaux de données (D1) au moyen d'un circuit d'extraction du signal d'horloge (24), et
• dériver le signal d'horloge (CLK) d'une horloge interne présentant un rapport en fréquence défini par rapport au débit d'un parmi le ou les signaux de données (D1).

3. Analyseur d'intervalle de temps (2, 2', 6) suivant la revendication 1 ou suivant l'une quelconque des revendications précédentes, en outre à même de déterminer un intervalle de temps (TM1, TM2) entre le premier flanc de signal (E1, E3) et le deuxième flanc de signal (E2, E4) en prenant la différence entre les temps de déclenchement (T1, T2) et une différence de temps (ΔT) obtenue entre la deuxième différence de temps (Δt2) et la première différence de temps (Δt1).

4. Analyseur d'intervalle de temps (2, 2', 6) suivant la revendication 2 ou suivant l'une quelconque des revendications précédentes, en outre à même de répéter la détermination des première et deuxième différences de temps (Δt1, Δt2) pour une pluralité d'intervalles de temps (T, nT) dans le ou les signaux de données (D1), et de déterminer des caractéristiques de gigue sur la base de variations des première et deuxième différences de temps (Δt1, Δt2) ou de variations de différences de temps résultant desdites première et deuxième différences de temps (Δt1, Δt2).

5. Analyseur d'intervalle de temps (2, 2', 6) suivant la revendication 4, dans lequel les caractéristiques de gigue sont dérivées d'au moins une valeur parmi les valeurs suivantes :
• valeurs moyennes des fonctions de distribution dans le temps de chaque première différence parmi les première et deuxième différences de temps (Δt1, Δt2) ;
• valeurs minimum et maximum d'une fonction de distribution par rapport à la différence de temps (ΔT) obtenue de la deuxième différence de temps (Δt2) et de la première différence de temps (Δt1).

6. Analyseur d'intervalle de temps (2, 2', 6) suivant la revendication 1 ou suivant l'une quelconque des revendications précédentes, dans lequel le circuit d'échantillonnage (21) fournit les valeurs d'échantillonnage (A1, A2) sous la forme de valeurs analogiques, de préférence de valeurs de tension, l'analyseur comprenant en outre un circuit convertisseur (23) à même de convertir la première valeur d'échantillonnage (A1) et la deuxième valeur d'échantillonnage (A2) en une première valeur numérique de plusieurs bits (V1) et une deuxième valeur numérique de plusieurs bits (V2), et le circuit d'analyse (50) étant à même de stocker le modèle de flanc sous la forme d'une pluralité de valeurs numériques ou sous la forme d'un algorithme fournissant des valeurs numériques.

7. Analyseur d'intervalle de temps (2, 2', 6) suivant la revendication 6, dans lequel le circuit d'échantillonnage (21) comprend un premier circuit échantillonneur-bloqueur (32) à même de recevoir la première impulsion de déclenchement (TR1) à son entrée de déclenchement et un signal parmi le ou les signaux de données (D1) à son entrée de signal, et un deuxième circuit échantillonneur-bloqueur (33) à même de recevoir la deuxième impulsion de déclenchement (TR2) à son entrée de déclenchement et ledit un signal parmi le ou les signaux de données (D1) ou un autre signal parmi le ou les signaux de données à son entrée de signal.

8. Analyseur d'intervalles de temps (2, 2', 6) suivant la revendication 7, comprenant au moins une des particularités suivantes :
• les sorties de signal des premier et deuxième circuits échantillonneurs-bloqueurs (32, 33) sont chacune connectées par une première porte et une deuxième porte de transfert (34, 35) au circuit convertisseur (23), et dans lequel le circuit de commande (60) est à même de fournir des signaux de commande de porte (GC1, GC2) de sorte que les première et deuxième portes de transfert (34, 35) fournissent alternativement la première valeur d'échantillonnage (A1) et la deuxième valeur d'échantillonnage (A2), respectivement, au circuit convertisseur (23, 36) ;
• un premier circuit convertisseur et un deuxième circuit convertisseur (36a, 36b) dans lesquels le premier circuit échantillonneur-bloqueur (32) est à même de fournir la première valeur d'échantillonnage (A1) au premier circuit convertisseur (36a), et le deuxième circuit échantillonneur-bloqueur (33) est à même de fournir la deuxième valeur d'échantillonnage (A2) au deuxième circuit convertisseur (36b) ;
• le circuit d'échantillonnage (21) comprend un premier circuit échantillonneur-bloqueur (301) à même de recevoir la première impulsion de déclenchement (TR1) et la deuxième impulsion de déclenchement (TR2) à son entrée de déclenchement et le signal de données (D1) à son entrée de signal, et deux circuits échantillonneurs-bloqueurs (302, 303) supplémentaires à même de recevoir chacun à leur entrée de signal un signal de sortie venant du premier circuit échantillonneur-bloqueur (301), et dans lequel le circuit de commande (60) est à même de fournir alternativement une troisième impulsion et une quatrième impulsion de déclenchement (TR21, TR22) à chacune des entrées de déclenchement dudit circuit échantillonneur-bloqueur (302, 303) supplémentaire.

9. Analyseur d'intervalle de temps (2, 2', 6) suivant la revendication 1 ou suivant l'une quelconque des revendications précédentes, dans lequel la valeur de signal définie représente un des éléments suivants : le centre géométrique par rapport au temps du modèle de flanc (EM1, EM2), le centre géométrique par rapport à la grandeur du modèle de flanc (EM1, EM2) et le point de transition le plus probable.

10. Analyseur d'intervalle de temps (2, 2', 6) suivant la revendication 1 ou suivant l'une quelconque des revendications précédentes, dans lequel le modèle de flanc (EM1, EM2) représente un des éléments suivants :
• une courbe polynomiale du meilleur ajustement d'un flanc de signal mesuré (E1, E2, E3, E4) ;
• une courbe à sections composée d'une ou de plusieurs sections linéaires ou polynomiales, ajustées au flanc de signal mesuré (E1, E2, E3, E4) ;
• une courbe composée d'une pluralité de courbes de flanc mesuré (E1, E2, E3, E4).

11. Analyseur d'intervalle de temps (2, 2', 6) suivant la revendication précédente, dans lequel le modèle de flanc (EM1, EM2) est stocké sous la forme d'un des éléments suivants :
• une formule mathématique ou un algorithme produisant une valeur de temps à partir d'une valeur de signal ;
• une table comprenant une pluralité de paires de valeurs de courbe et de valeurs de temps dudit modèle de flanc (EM1, EM2).

12. Analyseur d'intervalle de temps (2, 2', 6) suivant la revendication 1 ou suivant l'une quelconque des revendications précédentes, comprenant au moins un des éléments suivants :
• l'analyseur d'intervalle de temps est en outre à même d'échantillonner de manière répétitive le ou les signaux de données (D1) en une pluralité de points de temps de déclenchement successifs, par rapport à une transition entre signaux de sorte que les points de temps de déclenchement sont décalés au cours de la transition, et étant en outre à même de dériver le modèle de flanc (EM1, EM2) des valeurs échantillonnées correspondantes ;
• un filtre étant connecté entre une entrée de données et le circuit d'échantillonnage (21) pour diminuer la pente des flancs de signal (E1, E2, E3, E4) ;
• un deuxième circuit d'échantillonnage (40) à même de comparer le signal de données (D1) à un seuil (VTH) et d'attribuer, en réponse à un deuxième signal de déclenchement (TS1, TS2), des valeurs binaires (B1, B2, B3) en fonction de résultats de la comparaison correspondants, dans lequel le circuit d'analyse (50) à même d'attribuer à chaque intervalle de temps (TM1, TM2) un nombre défini de valeurs binaires successives (B1, B2, B3), dans lequel un ensemble de bits successifs représente au moins en partie un historique binaire apparu avant l'intervalle de temps.

13. Analyseur d'intervalle de temps (1) suivant la revendication 5, à même de trier chacun des intervalles de temps (TM1, TM2) selon leur historique binaire, en une pluralité de groupes différents, chaque groupe étant lié à une séquence unique d'un nombre défini formant un historique binaire unique.

14. Analyseur d'intervalle de temps (1) suivant la revendication précédente, en outre à même d'analyser le signal de données (D1) afin de déterminer une profondeur d'influence de bits antérieurs sur un bit actuel, et de déterminer le nombre de bits de l'historique binaire.

15. Procédé de détermination des caractéristiques temporelles d'un ou de plusieurs signaux de données (D1) comprenant une séquence d'une pluralité de bits, comprenant :
la fourniture d'une première valeur d'échantillonnage (A1) à un premier temps (T1) dans une région d'une première transition entre signaux (E1, E3) et la fourniture d'une deuxième valeur d'échantillonnage (A2) à un deuxième temps (T2) dans une région d'une deuxième transition entre signaux (E2, E4) du ou des signaux de données (D1) ;
la récupération d'un modèle de flanc (EM1, EM2) des flancs de signal (E1, E2, E3, E4) décrivant l'intensité du signal dans le temps du signal de données (D1);
**caractérisé par**
la détermination à partir dudit modèle de flanc d'une première différence de temps (Δt1) entre la première valeur d'échantillonnage (A1) et une valeur de signal définie et d'une deuxième différence de temps (Δt2) entre la deuxième valeur d'échantillonnage (A2) et la valeur définie, et
la détermination des caractéristiques de temporisation sur la base de la deuxième différence de temps (Δt2) et de la première différence de temps (Δt1).

16. Programme ou produit formant logiciel, de préférence stocké sur un support de données, pour exécuter l'ensemble des étapes du procédé suivant la revendication 15, lorsqu'il est exécuté sur un système de traitement de données, tel qu'un ordinateur.
